# EUROPÄISCHE PATENTANMELDUNG

(11) **EP 1 746 077 A1**
(43) Veröffentlichungstag der Anmeldung: **24.01.2007**
(21) Anmeldenummer: 05013340.4
(22) Anmeldetag: 21.06.2005
(51) Int. Cl.: C04B 35/536, C01B 31/04, C04B 41/88, C23C 14/18, H01R 39/24

(54) **Metallbeschichtete Graphitfolie**

(71) Anmelder: SGL CARBON AG, 65203 Wiesbaden (DE)
(72) Erfinder: Öttinger, Oswin, Dr., 86405 Meitingen (DE); Christ, Martin, Dr., 86517 Wehringen (DE); Fischer, Ludger, Dr., 53343 Wachtberg-Berkum (DE)

(57) **Zusammenfassung**

Die vorliegende Erfindung betrifft Graphitfolien mit einer höchstens 100 nm dicken Metallbeschichtung sowie deren Herstellung, beispielsweise durch kontinuierliches Bedampfen von Graphitfolie, und Verwendung. Trotz der nur geringen Dicke der Metallschicht lassen sich die Graphitfolien durch Löten miteinander oder mit anderen Bauteilen aus Metall oder metallbeschichteten Werkstoffen verbinden. Außerdem schützt die dünne Metallbeschichtung die Oberfläche der Graphitfolie gegen das Herausbrechen, Abblättern oder Abplatzen von Partikeln.

## Beschreibung

Die vorliegende Erfindung betrifft Graphitfolien mit einer höchstens 100 nm dicken Metallbeschichtung sowie deren Herstellung und Verwendung.

Graphitfolie wird durch Verdichten und Zusammenpressen von Graphitexpandat hergestellt. Graphitexpandat entsteht, wenn Graphiteinlagerungsverbindungen bzw. Graphitsalze, z.B. Graphithydrogensulfat oder Graphitnitrat, schockartig erhitzt werden. Dabei vergrößert sich das Volumen der Graphitpartikel um den Faktor 200 bis 400, und die Schüttdichte sinkt auf 2 bis 20 g/l. Das so erhaltene Graphitexpandat besteht aus wurm- oder ziehharmonikaförmigen, sperrigen Aggregaten. Werden diese Partikel unter Druck verdichtet, so verhaken und verzahnen sie sich untereinander. Aufgrund dieses Effekts lassen sich ohne Binderzusatz selbsttragende flächige Gebilde, z.B. Folien oder Platten, herstellen. Graphitfolie zeichnet sich aus durch hohe elektrische und thermische Leitfähigkeit in der Ebene, d.h. senkrecht zur Pressrichtung, und leichte Anpassung an benachbarte Oberflächen.

Für bestimmte Anwendungen ist es nötig, Graphitfolie an mindestens einer Oberfläche vollflächig oder teilweise mit einer Beschichtung aus Metall zu versehen. Diese Beschichtung kann verschiedene Funktionen erfüllen wie mechanische Verstärkung, Steigerung der thermischen und elektrischen Leitfähigkeit und Korrosionsschutz. Außerdem wird eine metallische Oberfläche insbesondere dann benötigt, wenn die Bauteile aus Graphitfolie durch Lötstellen oder Schweißverbindungen mit anderen, insbesondere metallischen Bauteilen oder mit anderen Bauteilen aus expandiertem Graphit verbunden werden sollen.

Das Patent US 5 100 737 offenbart flexible Schichtverbunde aus mindestens einer Lage Graphitfolie mit einer Metallschicht, beispielsweise aus Kupfer oder Nickel, auf mindestens einer ihrer Oberflächen. Die Dicke der Graphitfolie beträgt 0,1 bis 10 mm, die der Metallschicht 1 bis 200 µm, bevorzugt zwischen 3 und 50 µm. Die Schichtverbunde werden angewendet in elektrischen Abschirmungen, Dichtungen oder als Kühlkörper (heat sink). Gegebenenfalls sind auf den Graphit- oder/und Metallschichten zusätzliche Bindungsschichten vorgesehen, um mehrere derartige Schichtverbunde miteinander zu verbinden. Die Bindungsschicht kann als eine dünne Metallschicht (Dicke 1 bis 5 µm) oder als Adhäsivschicht ausgebildet sein.

Die Herstellung der Metallschichten erfolgt vorzugsweise durch chemische (d.h. stromlos mittels eines Reduktionsmittels) oder galvanische Abscheidung. Zwar werden andere Verfahren zur Metallbeschichtung, wie Besprühen mit dem geschmolzenen Metall, Thermisches Spritzen, Vakuumabscheidungstechniken oder CVD nicht grundsätzlich ausgeschlossen, jedoch sind diese Methoden wegen ihrer mangelnden Eignung für den kontinuierlichen Betrieb weniger bevorzugt. Außerdem werden die Schwierigkeiten, mit diesen Techniken dünne Schichten zu erzielen, hervorgehoben.

Aus dem Patent DE 28 17 371 C2 sind ebenfalls metallbeschichtete Graphitfolien bekannt. Stapelanordnungen solcher metallbeschichteter Graphitfolien werden als Schleifkörper in Kontaktbürsten elektrischer Maschinen eingesetzt. Das Aufbringen der Schicht kann nach den bekannten Dünnschichtverfahren erfolgen wie Elektroplattieren, chemisches stromloses Plattieren, Plasma- oder Ionenplattieren, Sputtern oder Aufdampfen. Die Aufdampftechnik ist bevorzugt, da hier eine besonders gute Haftung des Metalls an der Graphitfolie erreicht wird. In jedem Fall ist bei der Beschichtung eine Erwärmung der Graphitfolie auf mehr als 100 °C zu vermeiden, weil die Graphitfolie sonst zu stark ausgast und dadurch die Haftung des Metalls vermindert wird. Die Dicke der aufgebrachten Schichten liegt zwischen 0,1 und 500 µm, bevorzugt zwischen 1 und 50 µm.

Die vorliegende Erfindung betrifft Graphitfolie mit einer zumindest einseitigen, Metallbeschichtung, wobei die Metallschicht eine Dicke von höchstens 100 nm aufweist.
Insbesondere betrifft die Erfindung auch flächige, streifenförmige o.ä. Halbzeug aus Graphitfolie, wobei mindestens eine der Flachseiten und mindestens einer der Kanten des Halbzeugs eine metallische Beschichtung mit einer Dicke von höchstens 100 nm aufweist.
Die erfindungs gemäßen beschichteten Graphitfolien weisen mehrere vorteilhafte Eigenschaften auf. So wurde überraschenderweise festgestellt, dass sich trotz der nur geringen Dicke der Metallschicht die erfindungsgemäßen Grraphitfolien ohne Schwierigkeiten durch Löten mit anderen Bauteilen aus Metall oder metallbeschichtetem Graphit verbinden lassen.
Außerdem bewirkt die dünne Metallbeschichtung einen hervorragenden Schutz der Oberfläche der Graphitfolie und ggf. auch der Kanten eines Halbzeugs aus Graphitfolie gegen das Herausbrechen, Abblättern oder Abplatzen von Graphitpartikeln.
Eine weitere Aufgabe der Erfindung besteht darin, ein Verfahren bereitzustellen, um auf Graphitfolie Metallbeschichtungen herzustellen, deren Dicke 100 nm nicht überschreitet.

Die Erfindung betrifft ferner Kombinationen solcher beschichteten Graphitfolien sowie deren Anwendung.
Weitere Details und Vorzüge der Erfindung gehen aus der folgenden detaillierten Beschreibung und den Ausführungsbeispielen und Figuren hervor.

Figur 1 zeigt beispielhaft ein Bauteil, in welchem Halbzeuge aus erfindungsgemäß beschichteter Graphitfolie miteinander verlötet sind.
Figur 2 zeigt einen Kühlkörper, dessen Finnen aus im Befestigungsbereich erfindungsgemäß beschichteten Graphitfolien bestehen.

Das Metall oder die Metalle, mit denen die Graphitfolie beschichtet wird, werden entsprechend der beabsichtigten Anwendung ausgewählt. Beispielhaft genannt seien Beschichtungen aus Aluminium oder Kupfer, welche die Herstellung von Lötverbindungen zu anderen Bauteilen aus Metall oder metallbeschichteten Werkstoffen ermöglichen, sowie Beschichtungen aus Nickel, Silber, Gold oder Platinmetallen. Die Beschichtung kann mehrere Metalle enthalten.

Sollen ausgedehnte Flächen, beispielsweise Bahnen, aus Graphitfolie beschichtet werden, dann erfolgt beispielsweise mittels kontinuierlicher Bedampfung mit dem gewünschten Metall. Abhängig von der verwendeten Anlage kann es dabei vorteilhaft sein, die Graphitfolie durch einseitiges Kaschieren mit einer Kunststofffolie, z.B. einer Folie aus PET, zu verstärken, um die Reißfestigkeit zu erhöhen. Auf der unkaschierten Oberfläche wird die Graphitfolie nun einseitig mit Metall bedampft. Die Kunststofffolie wird nach erfolgter Bedampfung mechanisch wieder von der unbeschichteten Oberfläche der Graphitfolie entfernt.
Jedoch ist die Erfindung nicht an dieses Verfahren gebunden, zur Herstellung der erfindungsgemäßen beschichteten Graphitfolie geeignet sind auch andere Verfahren aus der Gruppe der "PVD"-Verfahren (physical vapour deposition) wie beispielsweise Beschichtung durch Zerstäuben (Sputtern) und durch Ionenstrahlverfahren
Alternativen zu diesen Herstellungsverfahren bestehen in der galvanischen oder stromlosen Abscheidung der Metallschicht.

Anstelle einer kontinuierlichen Bahn aus Graphitfolie können auch einzelne Halbzeuge aus Graphitfolie, die bereits die für die beabsichtigte Anwendung benötigte Größe und Form aufweisen, beispielsweise quadratische oder rechteckige Folienstücke oder Folienstreifen, mit einer Metallschicht eine Dicke von höchstens 100 nm versehen werden. Unter Halbzeug werden hier allgemein Gebilde aus Graphitfolie mit im Gegensatz zu kontinuierlichen Folienbahnen begrenzter flächiger Ausdehnung verstanden, wobei die Form dieser Fläche beliebig ist und sich im wesentlichen nach der beabsichtigen Anwendung richtet.
Diese Vorgehensweise hat den Vorteil, dass neben den Flachseiten auch die Kanten der Folienstücke beschichtet werden können. Beim Hantieren, Verarbeiten, Einbauen usw. sind nämlich insbesondere die Kanten der flächigen, streifenförmigen o.ä. Halbzeuge mechanischen Belastungen durch Stoß o.ä. ausgesetzt. Daher ist es ein besonders erwünscht, neben den Flachseiten auch die Kanten durch eine geeignete Beschichtung gegen das Herausbrechen, Abblättern oder Abplatzen von Graphitpartikeln zu schützen. Dies wird durch die Beschichtung gemäß der vorliegenden Erfindung ermöglicht.
Beim Bedampfungsverfahren muss ggf., um Abschattungseffekte an den Kanten der Folienstücke zu vermeiden, die Positionierung bzw. Ausrichtung der Bedampfungsquelle entsprechend variiert werden.

Falls gewünscht, können bestimmte Bereiche der Oberfläche der Graphitfolie maskiert werden, so dass sie unbeschichtet bleiben. So können durch die Beschichtung ausgewählter Bereiche auf der Oberfläche der Graphitfolie bestimmte Strukturen (Muster) gebildet werden.

Aus zunächst einseitig mit Metall beschichteten Graphitfolien können durch Laminieren von zwei einseitig beschichteten Folien, wobei die beschichteten Oberflächen jeweils nach außen gewandt sind, beidseitig, d.h. an beiden Außenseiten, mit Metall beschichtete Laminate aus Graphitfolien hergestellt werden.
Alternativ ist bei der Verwendung von Bedampfungsanlagen, die niedrigere Anforderungen an die Zugfestigkeit der zu beschichtenden Folie stellen, so dass keine Kaschierung nötig ist, auch eine beidseitige Beschichtung in einem Durchlauf möglich.

Die zu beschichtenden Graphitfolien haben eine Dichte von maximal 1,9 g/cm³, bevorzugt von 0,3 bis 1,9 g/cm³ und besonders bevorzugt von 0,3 bis 1,3 g/cm³.
Falls erforderlich, kann die Graphitfolie vor dem Aufbringen der Metallschicht mit einem Harz o.ä. imprägniert werden , um die Poren in der Folie zu füllen und zu schhießen. Dadurch wird verhindert, dass das auf der Folie abzuscheidende Metall ins Innere der Folie gelangt.

Besonders vorteilhaft ist eine Imprägnierung der Folie vor der galvanischen oder stromlosen Abscheidung von Metall aus einem Elektrolytbad, weil durch die Imprägnierung das Eindringen des flüssigen Elektrolyts in die Poren vermindert und so der Aufwand für die anschließende Trocknung der beschichteten Folie reduziert wird.

Die erfindungsgemäßen metallbeschichteten Graphitfolien können beispielsweise zur Übertragung, Ableitung und Verteilung von Wärme, z.B. in elektronischen Geräten benutzt werden.
Die Verwendung von Graphitfolie zum Wärmemanagement in elektronischen Geräten ist beispielsweise aus der Patentschrift US 6 482 520 bekannt Dieses Dokument offenbart eine Wärmemanagement-Vorrichtung umfassend eine Wärmequelle, die an einer ihrer äußeren Oberflächen mit einer der Wärmeableitung dienenden Graphitfolie, einem sogenannten Thermal Interface, in Kontakt steht. Optional steht die von der Wärmequelle abgewandte Oberfläche der Graphitfolie mit einem Kühlkörper in Kontakt. In einer in der Patentanmeldung US 2002/0163076 beschriebenen Weiterentwicklung dieses Thermal Interface wird vorgeschlagen, zur Vermeidung des Abblätterns von Graphitfolie die von der Wärmequelle abgewandte Oberfläche und ggf. auch die Kanten der Folie mit einer Schutzbeschichtung zu versehen. Es wurden Beschichtungen aus verschiedenen Kunststoffen vorgeschlagen. Diese Beschichtungen sind jedoch thermisch kaum leitfähig, so dass die eigentliche Funktion des Thermal Interface, Wärme abzuleiten, dadurch beeinträchtigt wird.
Im Gegensatz dazu verbinden die erfindungsgemäß vorgeschlagenen Metallbeschichtungen den Vorteil des Schutzes der Oberfläche gegen das Abblättern von Graphitpartikeln mit dem Vorteil thermischer Leitfähigkeit.
In Graphitfolie ist die Wärmeleitfähigkeit anisotrop ausgebildet mit Bevorzugung der Wärmeleitung in der Folienebene, in Metallen hingegen isotrop. Innerhalb der Graphitfolie kann also wegen der bevorzugt lateralen Wärmeausbreitung eine weite flächige Verteilung der Wärme erfolgen, während durch die Metallschicht, die aufgrund ihrer Isotropie auch quer zur Folienebene in hohem Maße Wärme leitet, die Einleitung von Wärme in die Graphitfolie oder die Ableitung von Wärme aus derselben bewirkt werden kann.

Aufgrund der Möglichkeit, Löt- und Schweißverbindungen herzustellen, lassen sich aus passend geformten flächigen Halbzeugen aus den erfindungsgemäßen beschichteten Graphitfolien, ggf. in Verbindung mit Bauteilen aus anderen metallbeschichteten Werkstoffen oder aus Metall, dreidimensionalen Strukturen aufbauen. Auf diese Weise können die erfindungsgemäßen beschichteten Graphitfolien beispielsweise zur Herstellung von Wärmetauschern, Kühlkörpern oder bipolaren Kühlplatten für Brennstoffzellenstacks verwendet werden. In diesen und weiteren denkbaren Anwendungen kann neben dem Vorteil der Erfindung, die Herstellung von Löt- und Schweißverbindungen zu ermöglichen, auch die erfindungsgemäße Kombination aus lateraler Leitung von elektrischem Strom bzw. Wärme in der Graphitfolie und isotroper Leitung von elektrischem Strom bzw. Wärme in der Metallschicht, ausgenutzt werden.
Die benötigten Halbzeuge, beispielsweise quadratische oder rechteckige Folienstücke oder Folienstreifen, werden aus der erfindungsgemäß beschichteten Graphitfolie ausgeschnitten oder ausgestanzt. Alternativ könnten auch aus einer unbeschichteten Folienbahn die gewünschten Halbzeuge ausgeschnitten oder ausgestanzt und diese dann beschichtet werden. Diese Vorgehensweise hat den Vorteil, dass neben den Flachseiten auch die Kanten der Halbzeuge mit der Metallbeschichtung versehen werden können, so dass die Halbzeuge auch im Bereich der Kanten gegen das Herausbrechen, Abblättern oder Abplatzen von Graphitpartikeln geschützt sind.
Auch Laminate aus metallbschichteten Graphitfolien können als Halbzeuge für den Aufbau dreidimensionaler Strukturen eingesetzt werden.

Für Anwendungsfälle, bei denen ein Befestigen der metallbeschichteten Graphitfolie mittels Löten oder Schweißen nicht möglich oder nicht geeignet ist, kann auf die Metallbeschichtung eine dünne Klebstoffschicht aufgetragen werden. Diese sollte jedoch so dünn wie möglich sein, um den Wärmeübergang zur Metallschicht nicht zu beeinträchtigen. Gute Ergebnisse wurden mit 10 µm dicken Klebstoffschichten erzielt.
Ist die nicht mit Metall beschichteten Seite der Graphitfolie ebenfalls zur Befestigung an einem anderen Bauteil vorgesehen, kann dies auf die gleiche Weise mit einer dünnen Klebstoffschicht geschehen.
Der Auftrag des Klebstoffs kann unmittelbar vor der Anwendung erfolgen. Alternativ können metallbeschichtete Graphitfolien mit einer Klebstoffschicht auf der Metallschicht oder/und auf der nicht mit Metall beschichteten Oberfläche vorgefertigt werden, die mit einer abziehbaren Kunststoffolie bedeckt und erst unmittelbar vor dem Gebrauch abgezogen wird.

### Ausführungsbeispiel 1:

### Verfahren zum Beschichten von Graphitfolie mit einer dünnen Metallschicht

Eine Bahn Graphitfolie mit der Dicke 0,4 mm und der Dichte 1,2 g/cm³ wurde einseitig mit PET-Folie der Dicke 12 µm kaschiert, um die Zugfestigkeit der Graphitfolie zu steigern. Die Länge der Folie betrug ca. 50 m, die Breite ca. 1 m. Dieser Folienverbund aus Graphit- und PET-Folie wurde in einer kontinuierlich arbeitenden Hochvakuum-Beschichtungsanlage einseitig auf der nicht von PET-Folie bedeckten Oberfläche der Graphitfolie mit Aluminium bedampft. Die Laufgeschwindigkeit der Folie in der Beschichtungsanlage betrug ca. 5 m/s. Zur Bestimmung der Dicke der Aluminiumschicht wurde eine 30 x 70 mm² große Probe aus dem beschichteten Folienverbund gestanzt. Die PET-Folie wurde mechanisch von der Probe entfernt. Mittels Atomemissionsspektroskopie (ICP-AES) wurde der Aluminiumgehalt des verbleibenden Graphit-Aluminium Schichtverbunds bestimmt (260 µg). Aus der Fläche der Probe und der Masse der Aluminiumschicht wurde die flächenbezogene Masse der Aluminiumschicht ermittelt (0,12 g/m²). Anhand der Dichte von Aluminium (2,7 g/cm³) wurde daraus die Dicke der aufgedampften Aluminiumschicht zu ca. 45 nm berechnet.

### Ausführungsbeispiel 2:

### Herstellung von Lötverbindungen zwischen erfindungsgemäß mit Aluminium beschichten Graphitfolien

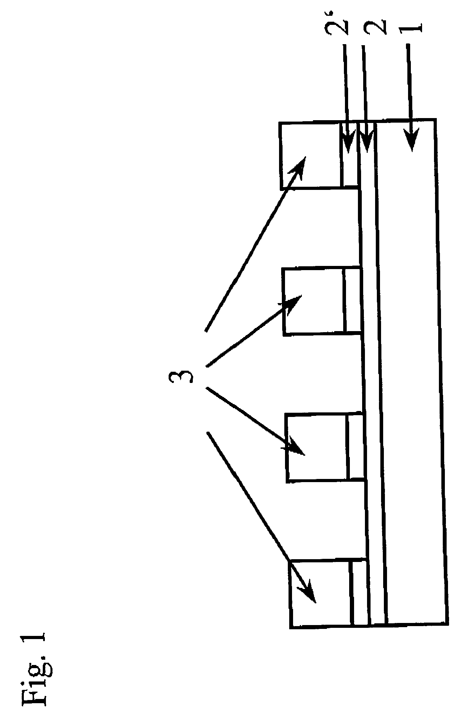

Auf eine entsprechend Ausführungsbeispiel 1 einseitig mit einer dünnen Aluminiumbeschichtung 2 versehene Graphitfolie 1 wurden Streifen 3 aus weiterer einseitig mit Aluminium 2' beschichteter Graphitfolie gelötet (siehe Figur 1)
Dazu wurde zunächst kommerziell erhältliches Hartlötpulver, das unter der Bezeichnung "Amasan" (Hersteller: Fa. Armack GmbH - Löttechnik) vertrieben wird und zum Löten von Aluminium und Leichtmetall ALU22 geeignet ist, mit Wasser angeteigt. Diese Masse wurde mit einem Pinsel auf die mit Aluminium beschichtete Seite der zu verlötenden Folienstreifen aufgebracht und mit Aluminiumpulver der Partikelgröbe < 100 µm (Hersteller: Fa. Schlenk Metallpulver GmbH & Co. KG) bestreut. Anschließend wurden die zu verlötenden Folienstreifen auf die mit Aluminium beschichtete Seite der nach dem in Ausführungsbeispiel 1 beschriebenen Verfahren beschichteten Graphitfolie gelegt und zwischen zwei Platten, die zur Fixierung dienten, in einen kalten Ofen eingebaut. Der Ofen wurde in ca. 2 h auf 650 °C aufgeheizt. Diese Temperatur wurde für 20 min gehalten, anschließend kühlien die Proben im Ofen aus.
Die aufgelöteten Folienstreifen hafteten sehr gut auf der Graphitfolie. Die zur Verstärkung während der Vakuumbeschichtung der Graphitfolie mit Aluminium auflaminierte PET-Folie brannte während der Ofenfahrt rückstaudsfrei ab. Durch die relativ langsame Aufheizung wurde Blasenbildung durch Ausgasen der Folie unterbunden.
Die Dicke der gelöteten Platten erhöht sich um ca. 0,4 mm (Lötschicht) an den übereinanderliegenden Stellen. Eine Aluminiumschicht kann optisch an diesen Stellen nicht mehr festgestellt werden.
Aus der so hergestellte Struktur entsprechend Figur 1 kann durch Auflöten einer weiteren erfindungsgemäßen beschichteten Graphitfolie auf die auf der ersten Graphitfolie 1 aufgelöteten Streifen 3 eine Kanalstruktur gebildet werden, die u.a. in Wärmetauschern einsetzbar ist.

### Vergleichsbeispiel zu Ausführungsbeispiel 2

In einem Vergleichsversuch wurden nach dem in vorstehend beschriebenen Verfahren Streifen von nicht beschichteter Graphitfolie auf nicht beschichtete Graphitfolie gelötet. Die Haftung zwischen den verlöteten Teilen war bei diesem Versuch deutlich geringer als bei den Lötverbindungen zwischen mit Aluminium beschichteten Graphitfolien. Einige der Streifen lösten sich komplett, andere zumindest teilweise von der Unterlage ab.

### Ausführungsbeispiel 3

### Kühlkörper mit eingelöteten Finnen aus Graphitfolie

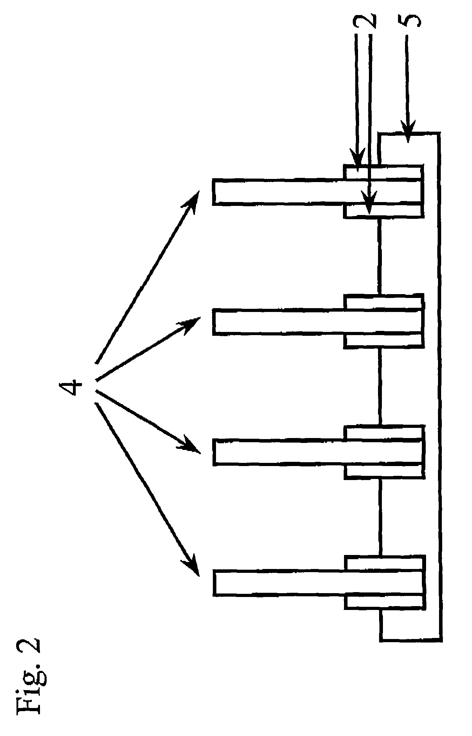

Der Kühlkörper gemäß Figur 2 enthält Kühlfinnen 4 aus Graphitfolie, die aus einer Grundplatte 5 herausragen und von dieser Wärme abführen. An der Oberfläche der Grundplatte 5, welche üblicherweise aus Metall besteht, sind Ausnehmungen zur Aufnahme der Kühlfinnen 4 vorgesehen. Die Kühlfinnen 4 sind in den Ausnehmungen der Grundplatte eingelötet. Dafür sind die Kühlfinnen 4 aus Graphitfolie zumindest in dem Bereich ihrer Oberfläche, der in die Ausnehmung hineinragt (der Befestigungsbereich), mit einer erfindungsgemäßen Metallbeschichtung versehen.
Alternativ kann eine Grundplatte aus Graphit verwendet werden, in welcher die Wandflächen der Ausnehmungen mit Metall beschichtet sind, so dass Finnen aus Graphitfolie, die im Befestigungsbereich mit einer erfindungsgemäßen Metallbeschichtung versehen sind, mittels Löten in den Ausnehmungen der Grundplatte befestigt werden können.

## Patentansprüche

1. Graphitfolie mit einer metallischen Beschichtung auf mindestens einer Oberfläche, **dadurch gekennzeichnet, dass** die Dicke der Beschichtung höchstens 100 nm beträgt.

2. Metallbeschichtete Graphitfolie nach Anspruch 1, **dadurch gekennzeichnet, dass** die Beschichtung mindestens eins der Metalle Aluminium, Kupfer Nickel, Silber, Gold oder Platinmetalle enthält.

3. Metallbeschichtete Graphitfolie nach Anspruch 1, **dadurch gekennzeichnet, dass** die Graphitfolie mit einem Harz imprägniert ist.

4. Metallbeschichtete Graphitfolie nach Anspruch 1 bis 3, **dadurch gekennzeichnet, dass** nur ausgewählte Bereiche der Oberfläche der Graphitfolie mit Metall beschichtet sind.

5. Metallbeschichtete Graphitfolie nach einem der Ansprüche 1 bis 4, **dadurch gekennzeichnet, dass** sich auf der Metallschicht oder/und auf der nicht mit Metall beschichteten Oberfläche eine Klebstoffschicht mit einer Dicke bis zu 10 µm befindet, die durch eine abziehbare Folie bedeckt ist.

6. Laminat aus zwei einseitig metallbeschichteten Graphitfolien gemäß Anspruch 1, wobei die Graphitfolien so angeordnet sind, dass ihre metallbeschichteten Oberflächen nach außen weisen, so dass beide Außenseiten des Laminats eine Metallbschichtung aufweisen.

7. Flächiges oder streifenförmiges Halbzeug aus Graphitfolie, **dadurch gekennzeichnet, dass** mindestens eine der Flachseiten und mindestens eine der Kanten des Halbzeugs eine metallische Beschichtung mit einer Dicke von höchstens 100 nm aufweisen.

8. Verwendung von metallbeschichteter Graphitfolie nach einem der Ansprüche 1 bis 5 Laminaten aus metallbeschichteter Graphitfolie nach Anspruch 6 bzw. Halbzeugen nach Anspruch 7 zur Übertragung, Ableitung oder Verteilung von Wärme, insbesondere in elektronischen Geräten.

9. Verwendung von metallbeschichteter Graphitfolie nach einem der Ansprüche 1 bis 4, Laminaten aus metallbeschichteter Graphitfolie nach Anspruch 6 bzw. Halbzeugen nach Anspruch 7 zur Herstellung von Wärmetauschern, Kühlkörpern oder bipolaren Kühlplatten für Brennstoffzellenstacks.

10. Verfahren zum Verbinden von Halbzeugen oder Bauteilen aus metallbeschichteter Graphitfolie nach einem der Ansprüche 1 bis 4, Laminaten nach Anspruch 6 bzw. Halbzeugen nach Anspruch 7 miteinander oder mit Halbzeugen oder Bauteilen aus anderen metallbeschichteten Werkstoffen oder aus Metall, **dadurch gekennzeichnet, dass** die Bauteile miteinander verlötet oder verschweißt werden.

11. Kühlkörper umfassend Kühlfinnen aus Graphitfolie und eine Grundplatte aus Metall mit Ausnehmungen oder eine Grundplatte aus Graphit mit Ausnehmungen, deren Wände metallbeschichtet sind, wobei die Finnen in den Ausnehmungen eingelötet sind,
**dadurch gekennzeichnet dass**
die Kühlfinnen aus Graphitfolie zumindest im in die Ausnehmungen hinein ragenden Oberflächenbereich mit einer Metallschicht gemäß Anspruch 1 beschichtet sind.

12. Verfahren zur Herstellung einer einseitigen metallischen Beschichtung auf Graphitfolie, umfassend die Schritte
• einseitiges Kaschieren einer Bahn aus Graphitfolie mit einer Kunststofffolie
• kontinuierliches Bedampfen mit dem gewünschten Metall in der gewünschten Schichtdicke
• mechanisches Entfernen der Kaschierung

13. Verfahren nach Anspruch 12, **dadurch gekennzeichnet, dass** die Graphitfolie mit einer Folie aus PET kaschiert wird.

14. Verfahren nach Anspruch 12, **dadurch gekennzeichnet, dass** die Graphitfolie mit einem Harz imprägniert ist.

15. Verfahren nach Anspruch 12, **dadurch gekennzeichnet, dass** ausgewählte Oberflächenbereiche, die unbeschichtet bleiben sollen, mit einer Maskierung abgedeckt werden.
